# EUROPEAN PATENT APPLICATION

(11) **EP 4 739 080 A1**
(43) Date of publication of application: **06.05.2026**
(21) Application number: 25212616.4
(22) Date of filing: 31.10.2025
(51) Int. Cl.: H10W 72/90, H10W 42/20, H10W 70/05, H10W 72/00, H10W 72/60, H10W 74/01

(54) **A METHOD OF MANUFACTURING A PLURALITY OF SEMICONDUCTOR DEVICES AS WELL AS A CORRESPONDING SEMICONDUCTOR DEVICE**

(30) Priority: 31.10.2024 NL 2038971
(71) Applicant: Nexperia B.V., 6534 AB Nijmegen (NL)
(72) Inventor: Poelma, Regnerus Hermannus, Nijmegen (NL); Brown, Adam, Manchester (GB); Khaderbad, Mrunal, Manchester (NL); Syré, Jörg, Hamburg (DE)
(74) Representative: Pjanovic, Ilija

(57) **Abstract**

A method of manufacturing a plurality of semiconductor devices, wherein the method comprises the steps of providing a carrier layer comprising a first surface and a second surface opposite to the first surface, attaching a first metallization layer to the first surface of the carrier layer, transferring a metal paste to the first metallization layer for creating first patterned metal pads and dicing the carrier layer to provide the plurality of semiconductor devices.

## Description

### Technical field

The present disclosure relates to the field of manufacturing semiconductor devices and, more specifically, to an efficient way of manufacturing semiconductor devices.

### Background

In the field of power semiconductors, device resistance is an important factor that may influence both performance and efficiency. The total device resistance can be broken down into three main components:
Resistance of the semiconductor switch. This is typically located in the top 2-10 micrometres of the silicon, Si, wafer.
Resistance of the silicon substrate. This typically refers to the resistance of the doped silicon, which initially measures around 500-800 micrometres in thickness.
Resistance of the package interconnects. These are the connections that link the semiconductor die to external circuits.

Lowering the overall resistance leads to better device performance and higher efficiency in the final product. Various strategies have been employed to minimize resistance in each of these areas, with notable advancements in recent years.

One method for reducing package resistance has been the replacement of traditional wire bond interconnects with soldered clip contacts. While this technique has proven effective, it comes with a downside: the solder used often contains lead, Pb, which includes radioactive isotopes. Over time, these isotopes emit alpha radiation that can damage the semiconductor structure or cause shifts in its electrical behaviour.

Another approach focuses on reducing the thickness of the silicon substrate. Typically, substrates are thinned through grinding and chemical stress relief to approximately 100 micrometres. However, in recent years, there has been a push toward thinning substrates even further, to 50 micrometres or below, in order to reduce resistance and enhance heat dissipation.

Unfortunately, the trade-off is that such thin wafers, particularly those with diameters of 200 mm or 300 mm, become highly fragile. This increased fragility can negatively impact mechanical yield during the manufacturing process.

In terms of improving the resistance of the current spreading layer, one solution has been to increase the thickness of the metallization on the top of the die. Historically, this layer has been less than 1 micrometre thick, but increasing it to 4 micrometres has been shown to reduce resistance and improve the overall performance of the device.

To address many of these issues, plating thick copper layers on the wafer's front side and/or backside has emerged as a solution. Copper layers between 10 and 20 micrometres thick offer several advantages. First, a copper layer of at least 11.8 micrometres is sufficient to block alpha radiation at particle energy levels of 5.5 MeV, providing significant protection for the semiconductor. This not only shields the semiconductor from radiation damage but also improves the long-term reliability of the device.

Moreover, thick copper metallization enhances the device's ability to handle high surge currents by reducing hotspots and spreading resistance. The copper layers can also bolster the mechanical strength of the wafer and individual dies, thereby improving both wafer yield and assembly yield during manufacturing. Additionally, copper layers can be soldered to, facilitating easier assembly to copper clips and offering a practical drop-in solution for clip bond assembly processes.

However, these benefits come with certain disadvantages. Wafer-level pad metallization, particularly when it involves thick layers (greater than 1 micrometre), is both costly and time-consuming. Achieving thick metallization on the front or back of a wafer often requires sophisticated processes such as physical vapor deposition, PVD, and galvanic electroplating. These techniques are typically combined with lithography, etching, and lift-off steps to create the desired patterned layers. A significant drawback of these thick metallization layers is their potential to complicate the wafer singulation process, where the wafer is diced into individual dies. If not carefully managed, thick backside metallization can negatively affect the quality of this dicing process.

While techniques such as copper layer plating offer significant improvements in resistance, mechanical robustness, and surge current performance, they also introduce complexities in the manufacturing process that must be carefully addressed to ensure high-quality, efficient power semiconductor devices.

### Summary

It would be advantageous to achieve a method of manufacturing semiconductor devices, wherein the method is more efficient compared to prior art solutions. It would further be advantageous to achieve corresponding semiconductor devices.

In a first aspect of the present disclosure, there is provided a method of manufacturing a plurality of semiconductor devices, wherein the method comprises the steps of:
- providing a carrier layer comprising a first surface and a second surface opposite to the first surface;
- attaching a first metallization layer to the first surface of the carrier layer;
- transferring a metal paste to the first metallization layer for creating first patterned metal pads,
- dicing the carrier layer to provide the plurality of semiconductor devices.

The inventors have found that it may be beneficial to introduce a so-called "power metal pad", which is realized by transferring a metal paste to the first metallization layer for creating first patterned metal pads.

The power metal pad is thus created based on metal paste and may involve subsequent techniques to solidify the metal paste. The metal paste may comprise all kinds of electrically-conducting particles, like copper or silver or the like, and may optionally comprise polymers or fillers.

In an example, the method further comprises the step of:
- creating a connection between the metal pads and a clip and or leadframe to form a clip-bonded product.

Solder may be used as a solder medium for connecting the metal pads, i.e. "power metal pads", to the clip or the leadframe. One of the differences and advantages for the "power metal pad" is that this solution is compatible with mass assembly of clip bonded products that use solder as the joining medium. Conventional solutions rely on using a sintering material for joining opposing surfaces together.

In an example, the method further comprises the step of:
- sintering said transferred metal paste to form a solidified metal layer.

Sintering is a process in semiconductor manufacturing, especially for solidifying metal pastes like silver or copper based metal pastes, which are used to form strong, conductive layers between components. During sintering, the metal paste is subjected to heat, pressure, or both, causing the small metal particles in the paste to fuse together. This fusion occurs at temperatures below the melting point of the metal, which allows the paste to solidify into a dense, solid structure without the metal losing its form. The result is a stable and highly conductive bond that provides both electrical and thermal connectivity.

The use of sintering to solidify metal pastes offers several advantages. Metal pastes, like silver or copper based pastes, exhibit excellent electrical conductivity, making them ideal for creating low-resistance pathways. Additionally, these materials have high thermal conductivity, which helps in efficiently dissipating heat from the semiconductor die to the package or heat sink.

Sintering creates a bond that is both mechanically strong and resistant to thermal fatigue, providing reliability in devices that are exposed to high temperatures or harsh operating conditions.

In an example, a porosity of the solidified metal layer is in a range of 1% to 30% and, preferably, between 5% - 10%.

In another example, the step of creating comprises:
- applying a solder paste or solder material or sinter paste to connect the methods to said clip or said leadframe.

In an example, the method further comprises the additional step of:
- attaching a second metallization layer to the second surface of the carrier layer prior to the step of dicing;
- transferring a metal paste to the to the second metallization layers, prior to the step of dicing, for creating second patterned metal pads.

The second metallization layers could, for example, be placed on a backside of the carrier layer opposite to the location of the first metallization layers.

In another example, a thickness of the first patterned metal pads exceeds alpha particle penetration depth, wherein the alpha particle penetration depth denotes a depth at which alpha particles are at least substantially absorbed by the metal pad.

This could be, for example, a thickness of at least 11 micrometres or the like, to sufficiently block alpha-radiation at particle energy levels of about 5.5MeV or something similar.

In another example, the thickness of the first patterned metal pads provide current redistribution and mechanical protection to said semiconductor dies as well as making corresponding surfaces suitable for soldering.

The first and/or second patterned metal pads may thus comprise a thickness of 1-50 um, preferably 5-35 um and even more preferably 20-30 um.

As mentioned before, the metal paste may be any of a copper-based paste, a silver-based paste, tin-based, gold-based, aluminium-based or an alloy of one or more of these metals. The metal paste may further comprise polymers and/or fillers.

In a further example, the step of transferring comprises any of screen printing or stencil printing or jetting or lifting the metal paste to the respective metallization layer.

In a second aspect of the present disclosure, there is provided a semiconductor device manufactured by a method in accordance with any of the previous examples.

It is noted that the advantages as explained with reference to the first aspect of the present disclosure, being the method of manufacturing semiconductor devices, are also applicable to the second aspect of the present disclosure, being the semiconductor device itself.

In an example, the created first patterned metal pads is a solidified metal layer, wherein an average porosity of the solidified metal paste, resulting in the metal layer, is in a range of 1% to 30% and, preferably, between 5% - 10%. This is thus the sintered metal layer.

It is noted that the porosity can be non-uniform in the layer. This would mean that the porosity may slightly vary over different parts of the solidified metal paste. However the averages porosity may be in the above mentioned ranges.

The porosity may be defined as a measure of the pores, which may be void or filled with a polymer, gar or other substance. Thus, a composite sintered material with connected micro/nano metallic particles with isolated regions of different morphology including pores, voids, cavities which may be filled with (fully or partially) with a polymer, gas or other substance. So between 5% - 10% porosity means that at least 90% - 95% is composed of conductive metal.

In another example, the semiconductor device is any of a Metal Oxide Semiconductor, MOS, Field Effect Transistor, FET, a Bipolar Junction Transistor, BJT, a Diode.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig. 1 discloses an example of a semiconductor device in accordance with the present disclosure,
Fig. 2 discloses a schematic illustration of the semiconductor die manufactured in accordance with an example of the present disclosure;
Fig. 3 discloses examples of a method of manufacturing semiconductor devices in accordance with the present disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

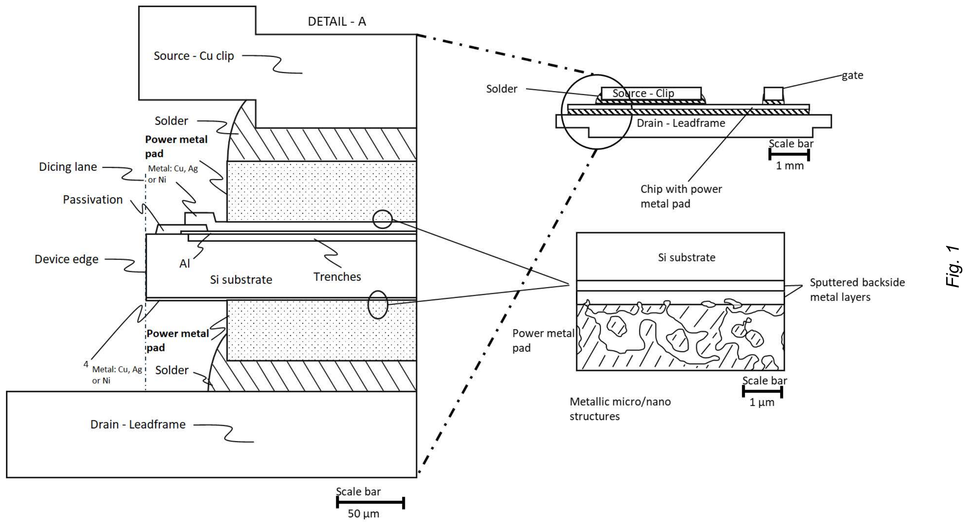

Fig. 1 discloses an example of a semiconductor device in accordance with the present disclosure.

In this disclose, sintering material may be used for creating a so-called power metal pad, such that the focus shifts towards developing a metal pad suitable for soldered interconnects. The disclosure introduces a novel approach to forming robust and reliable metal pads for semiconductor devices.

The sintered metal layers, applied to the front and/or back side of the device, may be screen printed using techniques such as stencil, lift, or jetting. These layers may be strategically positioned at a predetermined distance (A) from the edge of the device to prevent interference during the wafer dicing or singulation process. The first contact to the silicon is typically made via a thin PVD-deposited metal layer, such as aluminum, Al, which can be supplemented by additional layers like Ti/NiV/Ag. The thick metal pads may then be screen printed onto these thin metal layers, ensuring a durable foundation for further connections.

The "screen-printed front and back-side sinter metal pads" may be patterned to facilitate individual connections for gate, source, and drain terminals (or, in other devices, for emitter, base, collector, anode, and cathode). The front-side sinter metal pad may be designed to be relatively thick, typically ranging from 5 to 30 microns, compared to the much thinner PVD-deposited wafer front-side and back-side metal stacks, which are generally in the range of 100 nanometres to 1000 micrometres.

These relatively thick (C) metal contact pads may be created by screen printing (i.e. transferring) a sinter paste, which is somewhat porous (D) and features a microstructure. The sinter paste can also be customized with different types of fillers to adjust its properties and rheology, ensuring it may meet the specific requirements of processes such as clip attach and die attach. This method not only enhances the reliability of the soldered interconnects but also optimizes the performance and durability of the device in demanding applications.

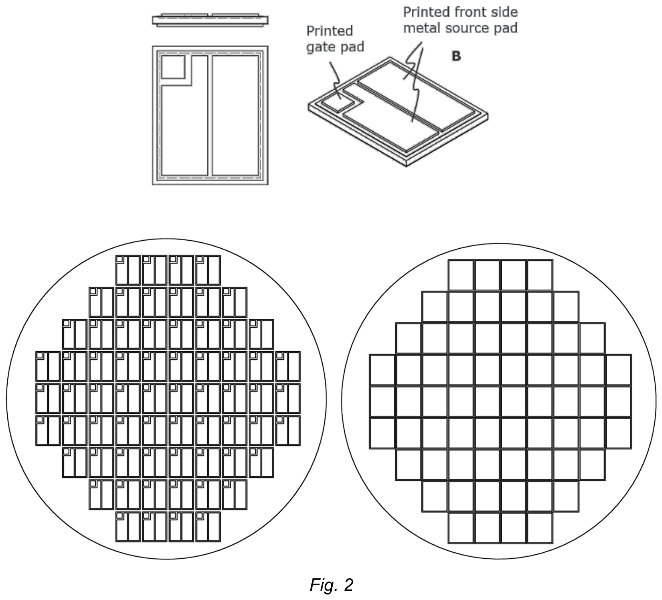

Fig. 2 discloses a schematic illustration of the semiconductor die manufactured in accordance with an example of the present disclosure.

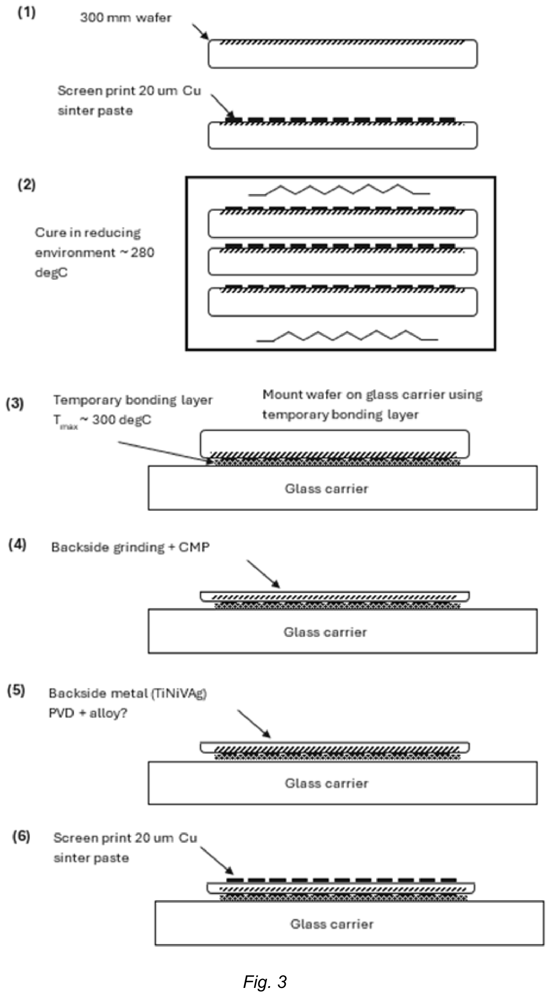

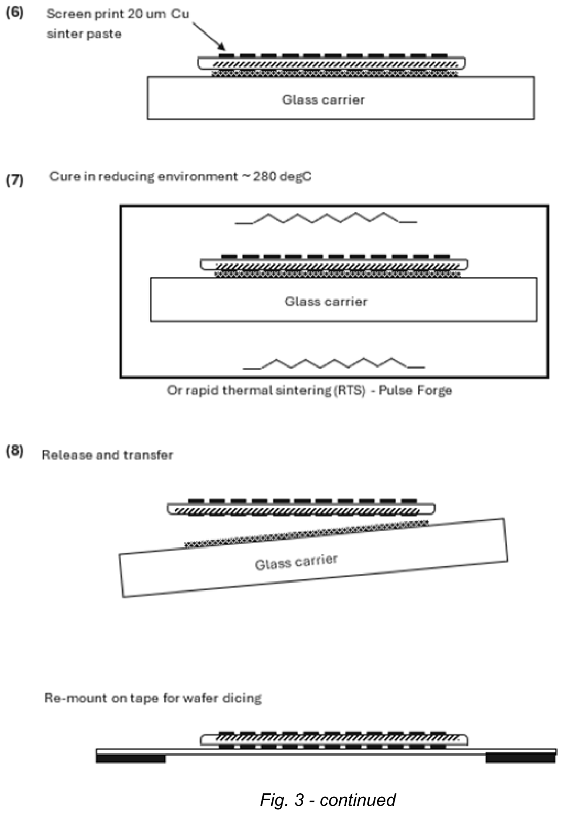

Fig. 3 discloses examples of a method of manufacturing semiconductor devices in accordance with the present disclosure.

The process outlined below details the fabrication of 300 mm wafers where the so-called "power metal pads" are provided on both sides of the wafer. This approach is used to improve the mechanical, electrical, and thermal properties of semiconductor devices, particularly for high-power applications.

While the process description focuses on 300 mm wafers, the methods and techniques described can be adapted to wafers of various dimensions, and the present disclosure can accommodate different configurations, such as single-sided or double-sided patterned metal pads, or multiple "power metal pads" on either side of the wafer. The schematics and drawings associated with the process should be viewed as illustrative rather than limiting in scope, as variations and customizations are possible.

To enhance the durability and performance of the wafer during processing, temporary bonding to a glass substrate may be employed. Temporary bonding adds mechanical strength to the wafer, particularly after thinning it through grinding. This mechanical support may remain in place until the back-side metallization is complete.

Alternative methods for providing temporary mechanical support can be considered as well. Grinding may, for example, leave a thicker edge to maintain structural integrity during back-side processing, but for larger wafers, such as 300 mm, the temporary bonding to glass provides a more effective solution.

A feature of this process is the patterned copper printing on both the front and back sides of the wafer. Copper is a conductive material, that may be useful for creating power interconnects, but it can be problematic during the dicing phase if left in the dicing lanes. By keeping copper out of the saw lanes, the process ensures that the saw blade will not cut through the copper during dicing.

This reduces mechanical wear on the saw blade, improves cutting quality, increases throughput, and reduces yield loss. The saw blade can move more efficiently through the wafer, resulting in smoother edges and fewer defects in the final product.

The first step involves screen printing a 20-micron layer of copper, Cu, sintering material on the front side of the wafer. This pattern may be designed to form power metal pads without interfering with the saw lanes. Once the front-side copper is printed, it may be cured (sintered) in a reducing environment at approximately 280°C. A formic acid bubbler may be introduced to facilitate the reduction of oxides that may have formed during the printing process. This step solidifies the copper and prepares it for further processing.

Next, the 300 mm wafer may temporarily be bonded to a glass carrier, for example measuring 320 x 352 mm. This temporary bond provides mechanical stability for the wafer during subsequent steps, particularly during grinding and back-side processing. Following the bonding process, the wafer may be thinned by back-side grinding down to 30 microns in thickness. This may be followed by wet chemical etching to remove surface irregularities and prepare the wafer for metallization.

Back-side metallization may then be performed using a technique such as PVD sputtering (e.g., TiNiVAg or TiWCu-seed layers). This forms a solid metal foundation on the back side of the wafer, which could be helpful for power dissipation and electrical conductivity. Once the back-side metallization is complete, a second layer of 20-micron Cu sintering material may be screen printed onto the wafer's back side, ensuring that copper does not encroach on the dicing lanes. The back-side copper may then be cured in a reducing environment, similar to the front side, at 280°C, ensuring a clean and conductive copper surface.

After all metallization and sintering processes are complete, the wafer may be released from the temporary glass carrier. The wafer may then be prepared for additional steps, where protective tape may be applied to ensure the wafer's integrity during dicing. Finally, the wafer may undergo the dicing process, where individual dies are cut from the wafer. The pre-designed saw lanes may ensure that copper is not present in the cutting paths, leading to clean, efficient dicing and high yield.

This process enables the creation of robust, double-sided power metal pads with precision copper patterning and high-quality dicing results. By using temporary bonding, careful copper deposition, and precise dicing techniques, this method ensures the production of high-performance semiconductor devices with enhanced mechanical and electrical characteristics.

Following the above, the present disclosure relates to the introduction of a "Power metal pad" which differs from the prior art in using a metal paste for creating the thick metallic pads at the wafer level. Traditional wafer-level metallization techniques, such as plating and lithography, are typically expensive and involve multiple complex steps. These methods require precise control over the deposition of metal layers and various processing stages, making them time-consuming and costly. In contrast, the Power metal pad introduces a low-cost solution that utilizes thick metallic sintered materials, which significantly simplifies the process. The microstructure and composition of these sintered metallic pads differ from conventional plated or sputtered metal pads, as demonstrated in Figure 1.

One of the most common applications of sintered materials is in the joining of two metallic surfaces, often eliminating the need for solder. However, the power metal pad may retain solder as the primary medium for forming interconnects between the sintered metal pad and other components such as the clip and leadframe. This presents a significant advantage, as the invention remains fully compatible with mass assembly processes that rely on clip bonding technology, where solder is still used as the joining material.

While conventional solutions often focus on using sintered materials for directly bonding surfaces, the power metal pad introduces a unique approach that integrates sintered materials into a low-cost, thick-film structure while preserving compatibility with established assembly techniques.

A feature of particular disclosure is the patterning of Copper or Silver metallic paste (metal paste) on front and/or back sides of the wafer, with deliberate care to keep copper out of the saw lanes. This design ensures that during the dicing process, the saw blade does not have to cut through the copper, which could otherwise lead to issues such as blade damage or poor saw quality. By preventing the saw from contacting copper, the invention leads to higher throughput, better saw quality, and reduced yield loss-all critical factors in the efficient mass production of semiconductor devices.

The sintered metal pads on the front and back of the wafer are relatively thick, typically ranging between 5 and 30 microns. This is thicker than the PVD-deposited metal stacks typically used in wafer metallization, which generally fall between 100 nanometers and 1000 microns. These thick pads are formed through screen printing or the transfer of sintered paste, which has a somewhat porous structure (as shown in Fig. 1D). The unique microstructure of the sintered paste offers advantages in terms of thermal and electrical performance, further enhancing the overall utility of the Power metal pad in semiconductor manufacturing.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims.

## Claims

1. A method of manufacturing a plurality of semiconductor devices, wherein the method comprises the steps of:
- providing a carrier layer comprising a first surface and a second surface opposite to the first surface;
- attaching a first metallization layer to the first surface of the carrier layer;
- transferring a metal paste to the first metallization layer for creating first patterned metal pads,
- dicing the carrier layer to provide the plurality of semiconductor devices.

2. A method in accordance with claim 1, wherein said method further comprises the step of:
- creating a connection between the metal pads and a clip and or leadframe to form a clip-bonded product.

3. A method in accordance with any of the previous claims, wherein said method further comprises the step of:
- sintering said transferred metal paste to form a solidified metal layer.

4. A method in accordance with claim 3, wherein a porosity of the solidified metal layer is in a range of 1% to 30% and, preferably, between 5% - 10%.

5. A method in accordance with any of the previous claims and at least to claim 2, wherein said step of creating comprises:
- applying a solder paste or solder material or sinter paste to create the connection to said clip or said leadframe.

6. A method of manufacturing according to any of the previous claims, wherein the method comprises the additional steps of:
- attaching a second metallization layer to the second surface of the carrier layer prior to the step of dicing;
- transferring a metal paste to the to the second metallization layers, prior to the step of dicing, for creating second patterned metal pads.

7. A method of manufacturing in accordance with any of the previous claims, wherein a thickness of the first patterned metal pads exceeds alpha particle penetration depth, wherein the alpha particle penetration depth denotes a depth at which alpha particles are at least substantially absorbed by the metal pad.

8. A method of manufacturing in accordance with any of the previous claims, wherein a thickness of the first patterned metal pads provide current redistribution and mechanical protection to said semiconductor dies as well as making corresponding surfaces suitable for soldering.

9. A method of manufacturing in accordance with any of the previous claims, wherein the first and/or second patterned metal pads comprises a thickness of 1-50 um, preferably 5-35 um and even more preferably 20-30 um.

10. A method of manufacturing in accordance with any of the previous claims, wherein the metal paste is any of a copper-based paste, a silver-based paste, tin-based, gold-based, aluminium-based or an alloy of one or more of these metals.

11. A method of manufacturing in accordance with claim 10, wherein the metal paste further comprises polymers and/or fillers.

12. A method of manufacturing in accordance with any of the previous claims, wherein the step of transferring comprises any of screen printing or stencil printing or jetting or lifting the metal paste to the respective metallization layer.

13. A semiconductor device manufactured by a method in accordance with any of the previous claims.

14. A semiconductor device in accordance with claim 13, wherein said created first patterned metal pads is a solidified metal layer, wherein a porosity of the solidified metal layer is in a range of 1% to 30% and, preferably, between 5% - 10%.

15. A semiconductor device in accordance with any of the claims 13 - 14, wherein said semiconductor device is any of a Metal Oxide Semiconductor, MOS, Field Effect Transistor, FET, a Bipolar Junction Transistor, BJT, a Diode.
